# EUROPEAN PATENT APPLICATION

(11) **EP 4 391 018 A1**
(43) Date of publication of application: **26.06.2024**
(21) Application number: 22858293.8
(22) Date of filing: 01.08.2022
(51) Int. Cl.: H01L 21/02

(54) **PROVISIONALLY BONDED WAFER AND METHOD FOR PRODUCING SAME**

(30) Priority: 17.08.2021 JP 2021132721
(71) Applicant: Shin-Etsu Handotai Co., Ltd., Tokyo 100-0004 (JP)
(72) Inventor: ISHIZAKI Junya, Annaka-shi, Gunma 379-0196 (JP)
(74) Representative: Mooser, Sebastian Thomas
(86) International application number: PCT/JP2022/029483
(87) International publication number: WO 2023/021972

(57) **Abstract**

The present invention provides a temporarily bonded wafer in which an epitaxial functional layer having two or more electrodes with different polarities on one surface and a support substrate are temporarily bonded, in which the surface having the electrodes of the epitaxial functional layer and the support substrate are temporarily bonded via an uncured thermosetting bonding material. This provides a technique to reduce bonding failure and delamination failure after removing the substrate after a bonding process, to improve the yield, and to easily remove the temporary support substrate.

## Description

### TECHNICAL FIELD

The present invention relates to a temporarily bonded wafer and a temporary bonding method for temporary bonding a semiconductor substrate to be mounted on a mounting substrate to a temporary support substrate for a temporary period.

### BACKGROUND ART

The technique to separate only an epitaxial functional layer, such as a light emitting element, from a starting substrate and transfer to another substrate is an important technique to mitigate a limitation due to a physical property of the starting substrate and improve a degree of design freedom for a device system. To realize the transfer, a technique is required to realize removing the starting substrate after bonding the epitaxial functional layer to a temporary support substrate and then transferring to a permanent substrate.

Patent Document 1 discloses a technique to perform thermo-compression bonding to a semiconductor epitaxial substrate and a temporary support substrate via a dielectric layer and a technique to separate the temporary support substrate and the epitaxial functional layer by wet etching. Patent Document 2 discloses a technique to insert a transparent conductive layer between an adhesive layer and a functional layer as one form of bonding, although not directly related to an improvement of bonding.

Patent Document 3 discloses a technique in which polyimide is used for temporary bonding; after a removal of a starting substrate, an electrode is formed on the surface where the substrate is removed.

### CITATION LIST

### PATENT LITERATURE

Patent Document 1: JP 2021-27301 A
Patent Document 2: JP 4159421 B2
Patent Document 3: JP 2008-187160 A

### SUMMARY OF INVENTION

### TECHNICAL PROBLEM

However, in Patent Document 3, an electrode is formed after temporary bonding and removal of a starting substrate, thus causing a problem of delaminating due to heat treatment in forming ohmic contact. In particular, when a material system with a large lattice mismatch or materials with large differences in thermal expansion coefficient are combined to form a heterostructure, the delamination rate tends to be large due to the bimetallic effect during the heat treatment.

To lower the temperature for ohmic contact formation, it is required to dope a dopant impurity with a concentration close to the solid solubility limit. However, a doped crystal layer having a concentration close to the solid solubility limit tends to have a lower quality of a crystal when compared to a relatively low doped crystal layer. A high-doped layer is needed to be provided between the starting substrate and a functional layer. Since the functional layer is provided above a high-doped layer, the functional layer is affected by the quality of the high-doped layer. In other words, a high-doped layer with low quality provided under the functional layer decreases the quality of the functional layer.

Moreover, to avoid an effect of thermal deformation due to bimetal, there is an idea to select a material system with a small difference in a coefficient of thermal expansion. However, it is impossible to select a material with a small difference in coefficient of thermal expansion while maintaining the function of the functional layer. Thus, only a selectable technical option is to reduce the difference in coefficient of thermal expansion; in other words, to thin the film thickness of each layer. Although designing a thin film thickness is technically possible, such thinning the thickness is highly likely unable to sufficiently control a carrier behavior in the functional layer due to a thinned film thickness; thus, the design function of the functional layer is degraded.

Based on a background described above, when an electrode is formed, and ohmic contact is formed after the temporary bonding of a support substrate, suppressing delamination due to a bimetallic effect is extremely difficult.

The present invention has been made in view of the above-described problem. An object of the present invention is to provide a technique for a temporarily bonded wafer in which the bonding failure and delamination failure after the removal of the starting substrate after a bonding process are reduced, the yield is improved, and the temporary support substrate can be easily removed.

### SOLUTION TO PROBLEM

To achieve the object, the present invention provides a temporarily bonded wafer in which an epitaxial functional layer having two or more electrodes with different polarities on one surface and a support substrate are temporarily bonded, wherein the surface having the electrodes of the epitaxial functional layer and the support substrate are temporarily bonded via an uncured thermosetting bonding material.

Such a temporarily bonded wafer in which the support substrate is temporarily bonded to the surface where the electrodes are formed with a thermosetting bonding material in an uncured state has no bonding or delamination failure in the temporarily bonded area, and the temporary support substrate can be easily removed because the bonding material is bonded in an uncured state.

In addition, the epitaxial functional layer is preferably a light emitting element.

The inventive temporarily bonded wafer can be used for this purpose.

Moreover, the epitaxial functional layer preferably contains an AlGaInP-based or InGaN-based material.

In particular, the present invention can be suitably used for the epitaxial functional layer containing these materials.

Furthermore, the thermosetting bonding material is preferably any of benzocyclobutene (BCB) resin, polyimide (PI) resin, fluororesin, and epoxy resin.

Such a thermosetting bonding material can not only temporarily bond in a softened state but also delaminate easily.

In addition, the support substrate is preferably comprised of any of the materials: silicon, sapphire, GaP, GaAs, InP, SiC, quartz, glass, LiTaO₃, and LiNbO₃.

In the present invention, for example, such a support substrate can be used.

Moreover, the inventive temporarily bonded wafer can have no starting substrate on a surface of the epitaxial functional layer opposite to the surface having the electrodes.

In this way, the inventive temporarily bonded wafer can be a wafer on which the starting substrate is removed.

Furthermore, the present invention provides a method for manufacturing a temporarily bonded wafer, the method being a method for temporarily bonding of an epitaxial substrate in which an epitaxial functional layer is grown on the starting substrate to a support substrate, the method comprising:
(1) forming two or more electrodes with different polarities on one surface of the epitaxial functional layer of the epitaxial substrate; and
(2) temporarily bonding the support substrate to the surface on which the electrodes are formed via an uncured thermosetting bonding material.

By manufacturing the temporarily bonded wafer in this way, temporary bonding is performed after forming electrodes, thus not subjected to a thermal restriction accompanied with electrode formation. Consequently, a bonding failure and a delamination failure between the epitaxial functional layer and the temporarily support substrate can be prevented. Thus, the yield can be improved. Moreover, temporary bonding with the temporary support substrate is performed where the bonding material is in an uncured state; thus, the temporary support substrate can be removed with ease.

In addition, the epitaxial functional layer is preferably a light emitting element.

The present invention can be used for manufacturing the temporarily bonded wafer having such a purpose.

Moreover, the epitaxial functional layer preferably contains an AlGaInP-based or InGaN-based material.

In particular, the present invention can be suitably used for the epitaxial functional layer containing such material.

Furthermore, the thermosetting bonding material is preferably any of benzocyclobutene (BCB) resin, polyimide (PI) resin, fluororesin, and epoxy resin.

Such a thermosetting bonding material is not only temporarily bondable in the softened state but also easy to delaminate.

In addition, the support substrate is preferably comprised of any of the materials: silicon, sapphire, GaP, GaAs, InP, SiC, quartz, glass, LiTaO₃, and LiNbO₃.

The present invention, for example, can use such a support substrate.

Moreover, the inventive method for manufacturing a temporarily bonded wafer may comprise after (2), (3) removing the starting substrate from the epitaxial substrate.

In this way, the temporarily bonded wafer without the starting substrate can be manufactured.

### ADVANTAGEOUS EFFECTS OF INVENTION

As described above, the present invention can provide a technique for a temporarily bonded wafer in which the bonding failure and delamination failure after the removal of the starting substrate after a bonding process are reduced, the yield is improved, and the temporary support substrate can be easily removed.

### BRIEF DESCRIPTION OF DRAWINGS

FIG. 1 is a view illustrating an example of a schematic view of a temporarily bonded wafer according to the present invention.
FIG. 2 is a view illustrating a schematic view in which an epitaxial substrate is manufactured by growing an epitaxial functional layer on a GaAs starting substrate in the first embodiment of a method for manufacturing a temporarily bonded wafer according to the present invention.
FIG. 3 is a view illustrating a schematic view in which a first electrode is formed on a GaP window layer in the first embodiment.
FIG. 4 is a view illustrating a schematic view in which an AlGaInP first cladding layer is exposed by dry etching in the first embodiment.
FIG. 5 is a view illustrating a schematic view in which a second electrode is formed on an AlGaInP first cladding layer in the first embodiment.
FIG. 6 is a view illustrating a schematic view in which the surface of an epitaxial functional layer, where an electrode is formed, is temporarily bonded to a support substrate via BCB resin, thereby manufacturing a temporarily bonded wafer in the first embodiment.
FIG. 7 is a view illustrating a schematic view in which a GaAs starting substrate is removed from a manufactured temporarily bonded wafer in the first embodiment.
FIG. 8 is a view illustrating a schematic view in which a temporarily bonded wafer having a GaAs starting substrate removed adheres to a silicon wafer via silicone; then, the support substrate is delaminated in the first embodiment.
FIG. 9 is a view illustrating a schematic view in which an epitaxial functional layer is grown on a sapphire starting substrate to manufacture an epitaxial substrate in the second embodiment of a method for manufacturing a temporarily bonded wafer according to the present invention.
FIG. 10 is a view illustrating a schematic view in which a first electrode is formed on a GaN contact layer in the second embodiment.
FIG. 11 is a view illustrating a schematic view in which a GaN first cladding layer is exposed by dry etching in the second embodiment.
FIG. 12 is a view illustrating a schematic view in which a second electrode is formed on a GaN first cladding layer in the second embodiment.
FIG. 13 is a view illustrating a schematic view in which the surface of an epitaxial functional layer, where an electrode is formed, is temporarily bonded to a support substrate via BCB resin, thereby manufacturing a temporarily bonded wafer in the second embodiment.
FIG. 14 is a view illustrating a schematic view in which a sapphire starting substrate is removed from a manufactured temporarily bonded wafer in the second embodiment.
FIG. 15 is a view illustrating a schematic view in which a temporarily bonded wafer having a sapphire starting substrate removed adheres to a silicon wafer via silicone; then, a support substrate is delaminated in the second embodiment.

### DESCRIPTION OF EMBODIMENTS

As described above, temporary bonding of a support substrate and then forming an electrode cause a problem of delamination due to heat treatment for the formation of ohmic contact. In particular, when a heterostructure is formed by combining a material system with a large lattice mismatch and a material with a large difference in coefficient of thermal expansion, the delamination rate tends to be enlarged due to a bimetallic effect at heat treatment.

To solve the above problem, the present inventors have earnestly studied and found out that by temporarily bonding the surface of an epitaxial functional layer having two or more electrodes of different polarities to a support substrate with a thermosetting bonding material in an uncured state, a temporarily bonded area has no delamination due to heat treatment during electrode formation, and since the thermosetting bonding material is bonded in an uncured state, the temporarily bonded support substrate can be removed very easily. Based on this finding, the present invention has been completed.

That is, the present invention is a temporarily bonded wafer in which the epitaxial functional layer having two or more electrodes with different polarities on one surface and a support substrate are temporarily bonded, wherein the surface having the electrodes of the epitaxial functional layer and the support substrate are temporarily bonded via an uncured thermosetting bonding material.

Hereinafter, the present invention will be described in detail. However, the present invention is not limited thereto.

### [Temporarily bonded wafer]

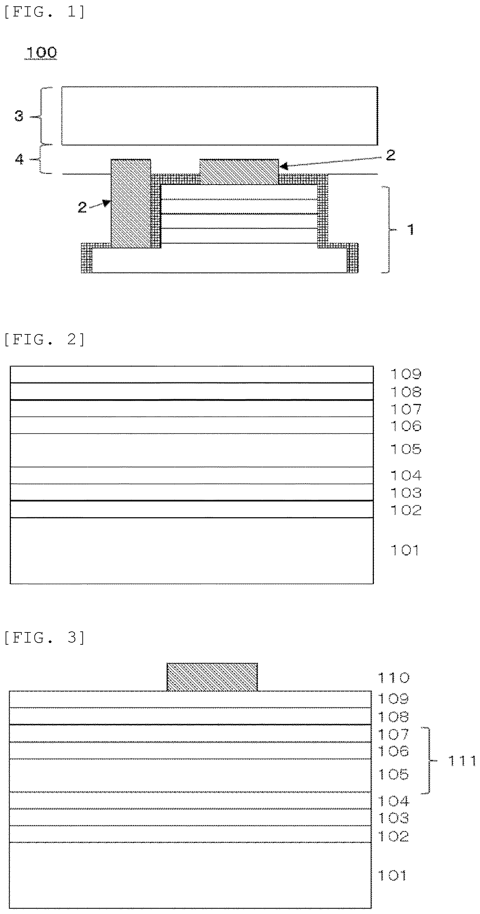

FIG. 1 shows an example of the inventive temporarily bonded wafer. In the inventive temporarily bonded wafer 100, an epitaxial functional layer 1 has two electrodes 2 with different polarities on one surface, and the surface having electrodes 2 of the epitaxial functional layer 1 and a support substrate 3 are temporarily bonded via an uncured thermosetting bonding material 4.

A conventional temporarily bonded wafer has a structure in which an electrode is formed on one surface of an epitaxial functional layer, and the other surface (the opposite surface to the electrode formation surface) is temporarily bonded to a support substrate. This is because in the conventional method for manufacturing the temporarily bonded wafer, firstly, the epitaxial layer of an epitaxial substrate, in which the epitaxial functional layer is formed on the starting substrate, is temporarily bonded to a support substrate, then, the starting substrate is removed, and the electrode is formed on the surface where the starting substrate is removed. In contrast, the inventive temporarily bonded wafer, unlike the conventional temporarily bonded wafer, has a structure in which the electrodes are placed between the epitaxial functional layer and the support substrate. The reason for this structure is that the wafer is manufactured by temporary bonding after the formation of the electrodes, according to the inventive method for manufacturing the temporarily bonded wafer, as described later.

### [Method for manufacturing temporarily bonded wafer]

Thus, the present invention provides a method for manufacturing a temporarily bonded wafer, the method being a method for temporarily bonding an epitaxial substrate in which an epitaxial functional layer is grown on a starting substrate to a support substrate, the method comprising:
(1) forming two or more electrodes with different polarities on one surface of the epitaxial functional layer of the epitaxial substrate; and
(2) temporarily bonding the support substrate to the surface on which the electrodes are formed via an uncured thermosetting bonding material.

Such a method for manufacturing the temporarily bonded wafer, unlike the conventional method in which heat treatment is performed to form an ohmic contact of electrodes (Ohmic heat treatment) to the wafer having a temporarily bonded portion, performs the electrode formation and ohmic heat treatment to the wafer before the formation of the temporarily bonded portion, then performs temporarily bonding with the support substrate. Consequently, heat treatment at a high temperature to form the electrodes does not cause delamination or thermal deformation at the temporarily bonded portion. Thus, the temporarily bonded wafer can be manufactured with an excellent yield. Furthermore, in the inventive method for manufacturing the temporarily bonded wafer, temporary bonding is performed via an uncured thermosetting bonding material. Thus, the support substrate is easily removed.

Hereinafter, the embodiments of the present invention will be described in detail with reference to drawings. However, the present invention is not limited thereto.

### (First embodiment)

With reference to FIG. 2 to FIG. 8, a first embodiment of the inventive method for manufacturing a temporarily bonded wafer is described. In the first embodiment, the epitaxial functional layer contains an AlGaInP-based material.

Firstly, as illustrated in FIG. 2, a GaAs buffer layer 102 of the first conductivity type is laminated on a GaAs starting substrate 101 of the first conductivity type, then the following layers are grown sequentially on the substrate: a Ga_{y}In_{1-y}P (0.4≤y≤0.6) first etching stop layer 103 of the first conductivity type having a thickness of e.g., 0.3 um; a GaAs second etching stop layer 104 of the first conductivity type having a thickness of e.g., 0.3 µm; a (AlₓGa₁₋ₓ)_{y}In_{1-y}P (0<x≤1,0.4≤y≤0.6) first cladding layer 105 of the first conductivity type having a thickness of e.g., 1.0 um; a non-doped (AlₓGa₁₋ₓ)_{y}In_{1-y}P (0≤x≤0.6,0.4≤y≤0.6) active layer 106; a (AlₓGa₁₋ₓ)_{y}In_{1-y}P (0<x≤1,0.4≤y≤0.6) second cladding layer 107 of the second conductivity type having a thickness of e.g., 1.0 µm; a Ga_{y}In_{1-y}P (0.45≤y≤1) intermediate layer 108 of the second conductivity type having a thickness of e.g., 0.1 um; a GaP window layer 109 of the second conductivity type having a thickness of e.g., 4 um; thus an epitaxial substrate having a light emitting element structure, which is a sequentially grown epitaxial functional layer, is provided. At this point, the AlGaInP first cladding layer 105 to the AlGaInP second cladding layer 107 are referred to as a double-hetero (DH) structure portion 111 (FIG. 3).

Then, as shown in FIG. 3, in a part of a region in the GaP window layer 109 of the second conductivity type, a first electrode 110 is formed. The use of highly reflective metal is suitable for the first electrode 110, and the electrode can be an Au-based electrode. For example, AuBe alloy can be used as the metal in contact with the GaP window layer 109, and Au can be laminated on the alloy. Thus, the first electrode 110 is formed.

The metal in contact with the GaP window layer 109 of the second conductivity type is not limited to AuBe alloys, but any metal or alloy can be selected as long as ohmic contact can be formed. In general, other than AuBe, an alloy such as AuZn is often selected.

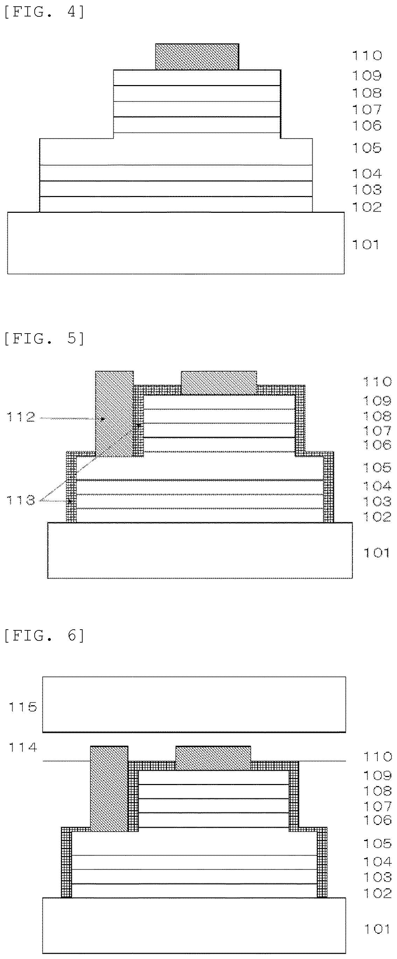

Then, as shown in FIG. 4, after the formation of the first electrode 110, a part of a region other than the first electrode 110 formation region on the GaP window layer 109 of the second conductivity type is coated with a mask using a material having etching selectivity such as SiO₂ or SiNx, and the exposed portion is notched by a method such as dry etching, and then the AlGaInP first cladding layer 105 of the first conductivity type is exposed.

Then, as shown in FIG. 5, the GaP window layer 109 of the second conductivity type, the side surface of the notched portion, and the AlGaInP first cladding layer 105 of the first conductivity type are coated with SiO₂ or SiNx as a PSV (passivation) film 113, then, the first electrode 110 portion and a part of the AlGaInP first cladding layer 105 of the first conductivity type are exposed by a photolithography method. Then, the second electrode 112 is formed on the exposed portion on the AlGaInP first cladding layer 105 of the first conductivity type.

The use of a highly reflective metal is suitable for the second electrode 112, and the electrode can be an Au-based electrode. For example, an AuSi alloy can be used as the metal to come in contact with the AlGaInP first cladding layer 105 of the first conductivity type, and Au can be laminated on the metal. Thus, the second electrode 112 is formed.

Furthermore, the metal in contact with the AlGaInP cladding layer 105 of the first conductivity type is not limited to AuSi alloys, but any metal or alloy can be selected as long as ohmic contact can be formed. In general, other than AuSi, alloys such as AuGe are often selected.

In addition, the PSV film 113 is not necessarily formed before the formation of the second electrode 112, and the PSV film 113 may be formed after the formation of the second electrode 112. Furthermore, the same effect can be obtained without the formation of the PSV film 113.

After the formation of the first and second electrodes 110 and 112, to obtain ohmic contact, for example, RTA heat treatment is performed at 400°C for 5 minutes. Although the case of RTA treatment is shown here as an example, the treatment is not limited to this RTA treatment, but may also be performed at relatively low temperatures, e.g., approximately 350°C for 30 minutes.

Then, as shown in FIG. 6, after the formation of ohmic contact, the electrode formation side is spin-coated with a BCB resin 114, then faced each other with the support substrate 115 selected from such as silicon, and then pressurized in a vacuum atmosphere and retained at 150°C for 15 minutes, and then temporarily bonded to the support substrate 115. Since the BCB resin 114 is cured by retaining the temperature condition above 150°C, the BCB resin 114 is prevented from being cured by retaining the temperature at 150°C or less. The uncured BCB resin 114 can improve the delamination property of the support substrate 115 from the epitaxial substrate.

In addition, the thermosetting bonding material is not limited to benzocyclobutene (BCB) resin; for example, the material can be polyimide (PI) resin, fluororesin, and epoxy resin.

Moreover, the support substrate 115 is not limited to silicon, but any material with excellent surface flatness can be selected, such as sapphire, GaP, GaAs, InP, quartz, glass, LiTaO₃, LiNbO₃, rock crystal, and SiC.

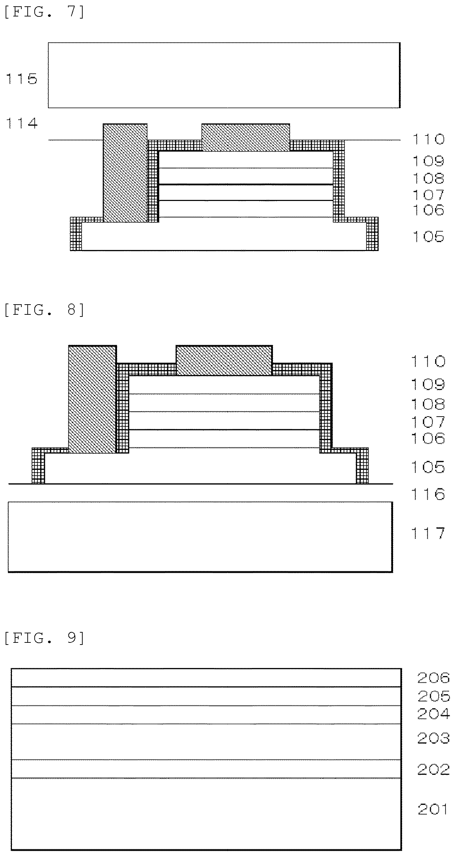

Then, as shown in FIG. 7, after the temporarily bonding to the support substrate 115, the starting substrate is removed by a selective etching method. The GaAs starting substrate 101 is removed by ammonia hydrogen peroxide water. The GaInP first etching stop layer 103 is removed by diluted hydrochloric acid or hydrochloric acid-based etchant, and lastly, the GaAs second etching stop layer 104 is removed by sulfuric acid-hydrogen peroxide mixture, and then the AlGaInP first cladding layer 105 of the first conductivity type is exposed. Consequently, the temporarily bonded wafer can be manufactured.

Lastly, as shown in FIG. 8, after exposing the AlGaInP first cladding layer 105 of the first conductivity type on the temporarily bonded wafer, this layer is adhered to a silicon wafer 117 coated with silicone 116, then BCB resin 114 in a softened state is dissolved by BCB solvent, thus delaminating the support substrate 115 and then individually divided chips are produced.

### (Second embodiment)

Using FIG. 9 to FIG. 15, a second embodiment of the inventive method for manufacturing a temporarily bonded wafer is described. In the second embodiment, the epitaxial functional layer includes InGaN-based material.

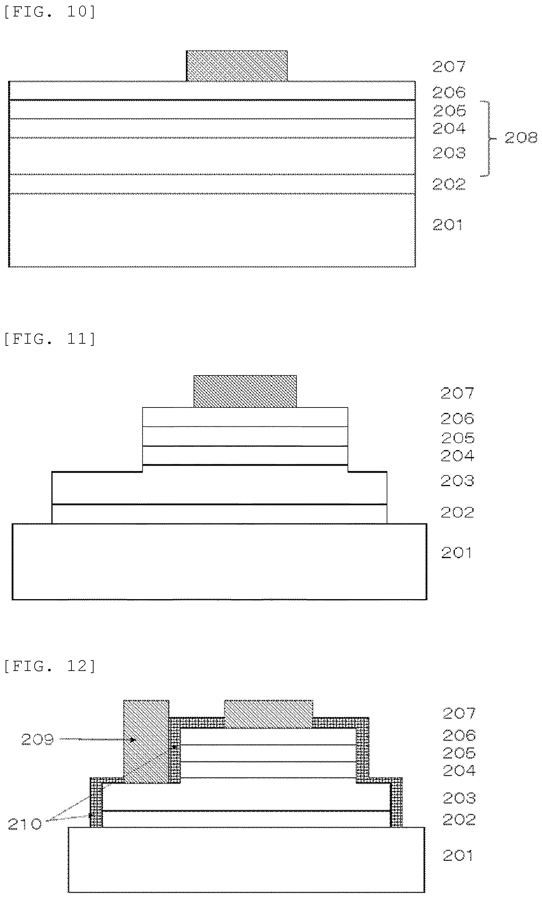

Firstly, as shown in FIG. 9, a GaN buffer layer 202 of the first conductivity type is laminated on a sapphire starting substrate 201, and then the following layers are grown sequentially on the substrate: a GaN first cladding layer 203 of the first conductivity type having a thickness, e.g., 1.0 µm; non-doped In_{z}Ga_{1-z}N (0<z≤0.4) active layer 204; an AlᵥGa₁₋ᵥN (0≤v≤0.4) (GaN) second cladding layer 205 of the second conductivity type having a thickness of e.g., 1.0 um; a GaN contact layer 206 of the second conductivity type having a thickness of e.g., 0.1 um; thus an epitaxial substrate having a light emitting element structure, which is a sequentially grown epitaxial functional layer, is provided. At this point, the GaN first cladding layer 203 to the AlGaN second cladding layer 205 are referred to as a double-hetero (DH) structure 208 (FIG. 10).

Then, as shown in FIG. 10, in a part of a region in the GaN contact layer 206 of the second conductivity type, a first electrode 207 is formed. The use of a highly reflective metal for the first electrode 207 is suitable, and the electrode can be an Ag-based electrode. Ag can be used as the metal in contact with the GaN contact layer 206, and Pd can be laminated on the metal. Thus, the first electrode 207 is formed.

Moreover, the metal in contact with the GaN contact layer 206 of the second conductivity type is not limited to an Ag-based metal, but any metal or alloy can be selected as long as ohmic contact can be formed. Generally, metals other than Ag, such as Au, and Ti, are often selected.

Then, as shown in FIG. 11, after the formation of the first electrode 207, a part of a region other than the first electrode 207 formation region on the GaN contact layer 206 of the second conductivity type is coated with a mask using a material having etching selectivity such as SiO₂ or SiNx, and the exposed portion is notched by a method such as dry etching. Then, the GaN first cladding layer 203 of the first conductivity type is exposed.

Then, as shown in FIG. 12, the GaN contact layer 206, the side surface of the notched portion, the GaN first cladding layer 203 are coated with SiO₂ or SiNx as a PSV film 210, then, the first electrode 207 portion and a part of the GaN first cladding layer 203 are exposed by a photolithography method. Then, the second electrode 209 is formed on the exposed portion of the GaN first cladding layer 203.

Moreover, the use of a highly reflective metal is suitable for the second electrode 209, and the electrode can be an Al-based electrode. For example, an Al metal can be used as the metal to come in contact with the GaN first cladding layer 203 of the first conductivity type, and Au can be laminated on the metal. Thus, the second electrode 209 is formed.

Furthermore, the metal in contact with the GaN first cladding layer 203 of the first conductivity type is not limited to Al metal, but any metal or alloy can be selected as long as ohmic contact can be formed. In general, other than Al, metals such as Ti or Au are often selected.

In addition, the PSV film 210 is not necessarily formed before the formation of the second electrode 209, and the PSV film 210 may be formed after the formation of the second electrode 209. Furthermore, the same effect can be obtained without the formation of the PSV film 210.

After the formation of the first and second electrodes 207 and 209, to obtain ohmic contact, for example, RTA heat treatment is performed at 700°C for 5 minutes.

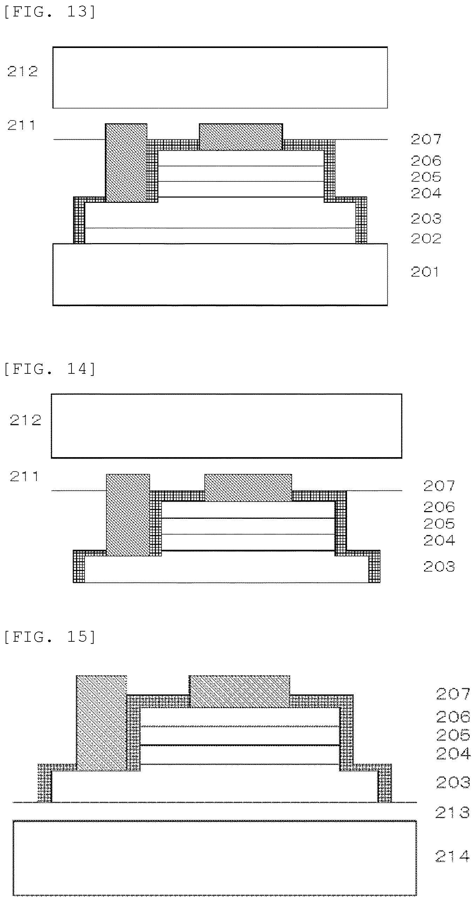

Then, as shown in FIG. 13, after the formation of ohmic contact, the electrode formation side is spin-coated with BCB resin 211, faced each other with the support substrate 212 selected from such as silicon, and then pressurized in a vacuum atmosphere and retained approximately at 150°C for 15 minutes, and then temporarily bonded to the support substrate 212. Since the BCB resin 211 is cured by retaining the temperature condition above 150°C, the BCB resin 211 is prevented from being cured by retaining the temperature at 150°C or less. The uncured BCB resin 211 can improve the delamination property of the support substrate 212 from the epitaxial substrate.

In addition, the thermosetting bonding material is not limited to benzocyclobutene (BCB) resin; for example, the material can be polyimide (PI) resin, fluororesin, and epoxy resin.

Moreover, the support substrate 212 is not limited to silicon, but any material with excellent surface flatness can be selected. Such as sapphire, GaP, GaAs, InP, quartz, glass, LiTaO₃, LiNbO₃, rock crystal, and SiC can be selected.

Then, as shown in FIG. 14, after temporary bonding, the GaN buffer layer 202 is irradiated by a laser from the starting substrate side for ablation, thus, the sapphire starting substrate 201 is removed, and the GaN first cladding layer 203 of the first conductivity type is exposed. Consequently, the temporarily bonded wafer can be manufactured.

Lastly, as shown in FIG. 15, after the GaN first cladding layer 203 of the first conductivity type is exposed, this layer adheres with a silicon wafer 214 on which silicone 213 is coated, then BCB resin 211 in softened state is dissolved by BCB solvent, thus delaminating the support substrate 212, and then individually divided chips are produced.

### EXAMPLE

Hereinafter, the present invention will be specifically described with reference to Examples and Comparative Example. However, the present invention is not limited thereto.

### (Example 1)

A GaAs buffer layer of the first conductivity type was laminated on a GaAs starting substrate of the first conductivity type, and then the following layers were grown sequentially on the substrate: a Ga_{y}In_{1-y}P (0.4≤y≤0.6) first etching stop layer of the first conductivity type having a thickness of 0.3 um; a GaAs second etching stop layer of the first conductivity type having 0.3 µm; a (AlₓGa₁₋ₓ)_{y}In_{1-y}P (0<x≤1,0.4≤y≤0.6) first cladding layer of the first conductivity type having a thickness of 1.0 um; a non-doped (AlₓGa₁₋ₓ)_{y}In_{1-y}P (0≤x≤0.6,0.4≤y≤0.6) active layer; a (AlₓGa₁₋ₓ)_{y}In_{1-y}P (0<x≤1,0.4≤y≤0.6) second cladding layer of the second conductivity type having a thickness of 1.0 µm; a Ga_{y}In_{1-y}P (0.45≤y≤1) intermediate layer of the second conductivity type having a thickness of 0.1µm; and a GaP window layer of the second conductivity type having a thickness of 4 um; thus an epitaxial substrate having a light emitting element structure, which was a sequentially grown epitaxial functional layer, was provided (see FIG. 2).

Then, a first electrode was formed in a part of a region on the GaP window layer of the second conductivity type. The use of a highly reflective metal was suitable for the first electrode; thus, an Au-based electrode was used. In this technique, AuBe alloy was used for the metal in contact with the GaP window layer, and Au was laminated on the alloy. Thus, the first electrode was formed (see FIG. 3).

After the formation of the first electrode, a part of a region of the GaP window layer of the second conductivity type, other than the area where the first electrode was formed, was coated with SiO₂, and the exposed portion was notched by dry etching, thus, the AlGaInP first cladding layer of the first conductivity type was exposed (see FIG.4).

The GaP window layer of the second conductivity type, the side surface of the notched portion, and the AlGaInP first cladding layer of the first conductivity type were coated with SiO₂ as a PSV film, then the first electrode portion and a part of the AlGaInP first cladding layer of the first conductivity type were exposed by a photolithography method. Then, the second electrode was formed on the exposed portion of the AlGaInP first cladding layer of the first conductivity type. At this point, the second electrode was formed using AuSi alloy as the metal in contact with the AlGaInP first cladding layer of the first conductivity type and laminating Au on the alloy (see FIG. 5).

After the formation of the first and second electrodes, to obtain ohmic contact, RTA heat treatment was performed at 400°C for 5 minutes.

After the formation of ohmic contact, the electrode formation side was spin-coated with BCB resin, then faced each other with a support substrate made of silicon, and then pressurized in a vacuum atmosphere and retained approximately at 150°C for 15 minutes, and then temporarily bonded to the support substrate (see FIG. 6) .

After the temporary bonding to the support substrate, the GaAs starting substrate was removed by ammonia hydrogen peroxide water, the GaInP first etching stop layer was removed by diluted hydrochloric acid or hydrochloric acid-based etchant, and lastly, the GaAs second etching stop layer was removed by sulfuric acid-hydrogen peroxide mixture. Thus, the AlGaInP first cladding layer of the first conductivity type was exposed (see FIG. 7)

After exposing the AlGaInP first cladding layer of the first conductivity type, the layer was adhered to a silicon wafer coated with silicone, then the BCB resin in a softened state was dissolved by BCB solvent, thus delaminating the support substrate, and then individually divided chips were produced (see FIG. 8).

### (Example 2)

A GaN buffer layer of the first conductivity type was laminated on a sapphire starting substrate, and then the following layers were grown sequentially on the substrate: a GaN first cladding layer of the first conductivity type having a thickness of 1.0 µm; non-doped In_{z}Ga_{1-z}N (0<z≤0.4) active layer; an AlᵥGa₁₋ᵥN (0≤v≤0.4) (GaN) second cladding layer of the second conductivity type having a thickness of 1.0 um; a GaN contact layer of the second conductivity type having a thickness of 0.1 µm; thus, an epitaxial substrate having a light emitting element structure, which is a sequentially grown epitaxial functional layer, is provided (see FIG. 9).

Then, in a part of a region of the GaN contact layer of the second conductive type, using Ag as the metal in contact with the GaN contact layer and laminating Pd thereon, the first electrode was formed (see FIG. 10).

After the formation of the first electrode, a part of a region of the GaN contact layer of the second conductivity type, other than the area where the first electrode was formed, was coated with SiO₂, and the exposed portion was notched by dry etching, thus, the GaN first cladding layer of the first conductivity type was exposed (see FIG.11).

The GaN contact layer, the side surface of the notched portion, and the GaN first cladding layer were coated with SiO₂ as a PSV film, then the first electrode portion and a part of the GaN first cladding layer were exposed by a photolithography method. Then, the second electrode was formed on the exposed portion of the GaN first cladding layer by using an Al metal as the metal in contact with the GaN first cladding layer of the first conductivity type and laminating Au on the Al metal (see FIG. 12).

After the formation of the first and second electrodes, to obtain ohmic contact, RTA heat treatment was performed at 700°C for 5 minutes.

After the formation of ohmic contact, the electrode formation side was spin-coated with BCB resin, faced each other with the support substrate made of silicon, and then pressurized in a vacuum atmosphere and retained approximately at 150°C for 15 minutes, and then temporarily bonded to the support substrate (see FIG. 13) .

After temporary bonding, the GaN buffer layer was irradiated by a laser from the starting substrate side for ablation, thus, the starting substrate was removed, and the GaN first cladding layer of the first conductivity type was exposed (see FIG. 14).

After the GaN cladding layer of the first conductivity type was exposed, this layer adhered with a silicon wafer on which silicone was coated, then the BCB resin in a softened state was dissolved by BCB solvent, thus delaminating the support substrate and then individually divided chips were produced (see. FIG.15).

### (Comparative Example)

After lamination of a GaAs buffer layer of the first conductivity type on a GaAs starting substrate of the first conductivity type, the following layers were grown sequentially: a Ga_{y}In_{1-y}P (0.4≤y≤0.6) first etching stop layer of the first conductivity type having a thickness of 0.3 um; a GaAs second etching stop layer of the first conductivity type having a thickness of 0.3 µm; a (AlₓGa₁₋ₓ)_{y}In_{1-y}P (0<x≤1,0.4≤y≤0.6) first cladding layer of the first conductivity type having a thickness of 1.0 um; a non-doped (AlₓGa₁₋ₓ)_{y}In_{1-y}P (0≤x≤0.6,0.4≤y≤0.6) active layer; a (AlₓGa₁₋ₓ)_{y}In_{1-y}P (0<x≤1,0.4≤y≤0.6) second cladding layer of the second conductivity type having a thickness of 1.0 µm; a Ga_{y}In_{1-y}P (0.45≤y≤1) intermediate layer of the second conductivity type having a thickness of 0.1 um; a GaP window layer of the second conductivity type having a thickness of 4 um; thus an epitaxial substrate having a light emitting element structure, which was a sequentially grown epitaxial functional layer, was provided.

The epitaxial substrate was spin-coated with 1.0 um of BCB resin, faced and superimposed with a sapphire wafer, and thermocompression-bonded. Thereby, an epitaxial bonded substrate in which the epitaxial substrate and the sapphire wafer was bonded with each other via BCB was manufactured. During the bonding, the curing process was performed by retaining at 250°C for 1 hour.

The GaAs starting substrate was removed by ammonia hydrogen peroxide water and the GaInP first etching stop layer was exposed. By switching the etchant to hydrochloric acid-based, the GaInP first etching stop layer was removed, and the GaAs second etching stop layer was exposed. By switching the etchant to sulfuric acid-hydrogen peroxide mixture-based, the GaAs second etching stop layer was removed, and the first cladding layer was exposed. By performing the processes above, the epitaxial bonded substrate having only a double-hetero layer and a window layer was manufactured.

After removing the starting substrate, AuBe-based was used as the metal in contact with the starting substrate-removal surface (first cladding layer), and Au was laminated on the top to form the first electrode.

After forming the first electrode, a part of a region of the first cladding layer, other than the area where the first electrode was formed, was notched by dry-etching, and the second cladding layer was exposed on the notched portion.

The AlGaInP first cladding layer, the side surface of the notched portion, and the AlGaInP second cladding layer were coated with a passivation (PSV) film; then, the first electrode portion and a part of the AlGaInP second cladding layer were exposed by a photolithography method. Then, the second electrode made of Au was formed on the exposed portion of the second cladding layer.

After forming the first and second electrodes, RTA heat treatment was performed at 400°C for 5 minutes to obtain ohmic contact.

After adhesion with a silicone-coated wafer, a laser was irradiated from the support substrate side for ablation, and then the support substrate and the element were separated.

### (Comparison of results between Examples and Comparative Example)

Temporarily bonded wafers manufactured in Examples 1 and 2, and Comparative Example were compared in light of area yield, doping level, area yield when P-CVD is adopted, and leakage failure rate as follows.

### [Area yield]

Table 1 shows a comparison of yield (ratio of adhesive area). In Example 1 and Example 2, since the electrode formation process and the element separation process were completed before temporary bonding, the temporarily bonded area was not delaminated or deformed by an ohmic heat treatment, and the process was performed to a wafer with excellent flatness and warpage. Consequently, the yield of the electrode formation process and the element separation process was maintained at a comparable level with the non-bonded wafers. On the other hand, in Comparative Example, a wafer having a temporarily bonded portion was applied to high-temperature RTA heat treatment, and the temporarily bonded portion was delaminated or deformed. Thus, a sufficient yield was not obtained.

**[Table 1]**

| | Example 1 | Example 2 | Comparative Example |
|---|---|---|---|
| Effective Area | 97%∼99% | 96%∼99% | 10∼47% |

### [Doping Level]

Even with applying curing treatment, a BCB film loses bonding strength when the film exceeds the softening point. Therefore, a high temperature processing should not be performed. To form ohmic contact, it is required to employ one of the following methods: the process is performed at a temperature higher than the softening point of BCB; and the metal contact layer is highly doped to avoid high-temperature treatment. However, heat treatment above the BCB softening point tends to induce deformation of the BCB bonded layer, leading to a decrease in an element yield. On the other hand, a highly doped contact layer easily induces an element degradation during energization through electromigration effect during energization, leading to performance degradation. When the process for electrode formation and element separation is performed in a wafer state where a BCB bonded wafer has not been formed, it is possible to effectively avoid the thermal restriction and the restrictions in designing an epitaxial substrate. Therefore, it is possible to increase the degree of freedom in design and avoid quality degradation of the element due to the process restriction.

Doping levels required for the first and the second electrode contact layers in Example 1, Example 2, and Comparative Example are shown in Table 2. In Examples, high-temperature heat treatment during electrode formation is possible. Consequently, ohmic contact can be obtained at the doping level of 10 to the power of seventeen. On the other hand, in Comparative Example, an ohmic heat treatment for electrode formation is performed on a wafer including a BCB temporarily bonded portion; thus, when a high-temperature treatment is performed, the temporarily bonded potion is delaminated. Consequently, in Comparative Example, heat treatment at a low temperature is needed to maintain a high yield. Thus, the doping level of 10 to the power of eighteen level is needed.

When a cladding layer having a doping level of 10 to the power of eighteen is formed, a defect tends to occur in an active layer due to electromigration during energization; it is highly possible that the element is degraded by energizing. A light-emitting element doped at 10 to the power of eighteen level shows a satisfied quality only in the initial characteristic but cannot show a satisfied quality in the transient characteristic. In Examples, since an epitaxial layer having a one-digit lower doping level can be introduced, the problem produced in Comparative Example, in which an unsatisfactory transient characteristic is produced, can be avoided.

**[Table 2]**

| | Example 1 | Example 2 | Comparative Example |
|---|---|---|---|
| First electrode contact layer | 1∼5E+17[/cm³] | 1∼3E+17[/cm³] | 1∼2E+18[/cm³] |
| Second electrode contact layer | 1∼5E+17[/cm³] | 1∼5E+17[/cm³] | 1∼2E+18[/cm³] |

### [Area yield when P-CVD is adopted]

To form SiO₂ as a PSV film, a film-forming method such as P-CVD is needed, and a heat environment of 400°C or more is needed due to a factor of the material reaction system. When the film-forming is performed by P-CVD after BCB bonding (Comparative Example), the film-forming needs to be performed under the condition of the BCB softening point. Thus, deformation of the BCB film is likely to occur during film-forming. Deformation of the BCB film is manifested as an uplift (delamination) phenomenon of the epitaxial layer, eventually leading to delamination of the uplift portions, thereby decreasing the yield.

Table 3 shows the yield when the P-CVD process is introduced (adhesive area ratio). As shown in Table 3, high yields were obtained in Examples; by contrast, in Comparative Example, in which the PSV film formation process was performed after the temporary bonding, the yield was decreased due to the occurrence of the delamination at the bonding portion during PSV film-forming process.

**[Table 3]**

| | Example 1 | Example 2 | Comparative Example |
|---|---|---|---|
| Effective Area | 97%∼100% | 95%∼100% | 16∼68% |

### [Leakage failure rate]

If the PSV film is only a hard mask, a film-forming method other than a P-CVD method, e.g., a physical film-forming method, can be selected. However, in the PSV film formation, the physical film-forming method has a poor coverage rate at the side surface, thus having a problem that cannot suppress a leakage occurring at the side surface.

Therefore, as shown in Table 4, Comparative Example that cannot adopt the most suitable P-CVD method for the PSV film-forming had a higher leakage failure rate compared with Example 1 and Example 2, which were able to adopt the P-CVD method.

**[Table 4]**

| | Example 1 | Example 2 | Comparative Example |
|---|---|---|---|
| Leakage failure rate | 0.01%∼3.75% | 0.01%∼4.11% | 58∼100% |

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A temporarily bonded wafer in which an epitaxial functional layer having two or more electrodes with different polarities on one surface and a support substrate are temporarily bonded, wherein
the surface having the electrodes of the epitaxial functional layer and the support substrate are temporarily bonded via an uncured thermosetting bonding material.

2. The temporarily bonded wafer according to claim 1, wherein
the epitaxial functional layer is a light emitting element.

3. The temporarily bonded wafer according to claim 1 or 2, wherein
the epitaxial functional layer contains an AlGaInP-based or InGaN-based material.

4. The temporarily bonded wafer according to any one of claims 1 to 3, wherein
the thermosetting bonding material is any of benzocyclobutene (BCB) resin, polyimide (PI) resin, fluororesin, and epoxy resin.

5. The temporarily bonded wafer according to any one of claims 1 to 4, wherein
the support substrate is comprised of any of the materials: silicon, sapphire, GaP, GaAs, InP, SiC, quartz, glass, LiTaO₃, and LiNbO₃.

6. The temporarily bonded wafer according to any one of claims 1 to 5, wherein
the wafer does not have a starting substrate on a surface of the epitaxial functional layer opposite to the surface having the electrodes.

7. A method for manufacturing a temporarily bonded wafer, the method being a method for temporarily bonding an epitaxial substrate in which an epitaxial functional layer is grown on a starting substrate to a support substrate, the method comprising:
(1) forming two or more electrodes with different polarities on one surface of the epitaxial functional layer of the epitaxial substrate; and
(2) temporarily bonding the support substrate to the surface on which the electrodes are formed via an uncured thermosetting bonding material.

8. The method for manufacturing a temporarily bonded wafer according to claim 7, wherein
the epitaxial functional layer is a light emitting element.

9. The method for manufacturing a temporarily bonded wafer according to claim 7 or 8, wherein
the epitaxial functional layer contains an AlGaInP-based or InGaN-based material.

10. The method for manufacturing a temporarily bonded wafer according to any one of claims 7 to 9, wherein
the thermosetting bonding material is any of benzocyclobutene (BCB) resin, polyimide (PI) resin, fluororesin, and epoxy resin.

11. The method for manufacturing a temporarily bonded wafer according to any one of claims 7 to 10, wherein
the support substrate is comprised of any of the materials: silicon, sapphire, GaP, GaAs, InP, SiC, quartz, glass, LiTaO₃, and LiNbO₃.

12. The method for manufacturing a temporarily bonded wafer according to any one of claims 7 to 11, the method further comprising: after (2),
(3) removing the starting substrate from the epitaxial substrate.
